# EUROPÄISCHE PATENTANMELDUNG

(11) **EP 1 213 768 A2**
(43) Veröffentlichungstag der Anmeldung: **12.06.2002**
(21) Anmeldenummer: 01127734.0
(22) Anmeldetag: 21.11.2001
(51) Int. Cl.: H01L 29/78, H01L 29/06

(54) **Mittels Feldeffekt steuerbares Halbleiterbauelement**

(30) Priorität: 11.12.2000 DE 10061528
(71) Anmelder: Infineon Technologies AG, 81669 München (DE)
(72) Erfinder: Ahlers, Dirk, 80796 München (DE); Stengl, Jens-Peer, 82284 Grafrath (DE); Tihanyi, Jenö, 85551 Kirchheim (DE); Weber, Hans, 83404 Ainring (DE); Deboy, Gerald, 81543 München (DE); Strack, Helmut, 80804 München (DE); Willmeroth, Armin, 86163 Augsburg (DE)
(74) Vertreter: Patentanwälte Westphal, Mussgnug & Partner

(57) **Zusammenfassung**

Die vorliegende Erfindung betrifft ein Halbleiterbauelement mit in einem Halbleiterkörper (10) ausgebildeten ersten und zweiten Anschlußzonen (12, 20A, 20B), einer die zweite Anschlußzone (20A, 20B) in dem Halbleiterkörper (10) umgebende Kanalzone (30A, 30B), einer zwischen der Kanalzone (30A, 30B) und der ersten Anschlußzone (12) ausgebildeten Driftstrecke (14), in der eine Kompensationszone angeordnet ist. Die Kompensationszone (60A, 60B) ist vom komplementären Leitungstyp wie die Drift-Zone (14) und weist wenigstens zwei Segmente (62A, 64A, 62B, 64B) auf, wobei der Abstand zwischen den zwei benachbarten Segmenten derart gewählt ist, daß die Punch-Through-Spannung zwischen diesen Segmenten in einem Spannungsbereich liegt, der dem Spannungsbereich entspricht, den der Spannungsabfall über der Driftstrecke bei Strömen annimmt, die zwischen einfachem und doppeltem Nennstrom liegen.

## Beschreibung

Die vorliegende Erfindung betrifft ein Halbleiterbauelement, insbesondere einen MOS-Transistor, gemäß den Merkmalen des Oberbegriffs des Anspruchs 1.

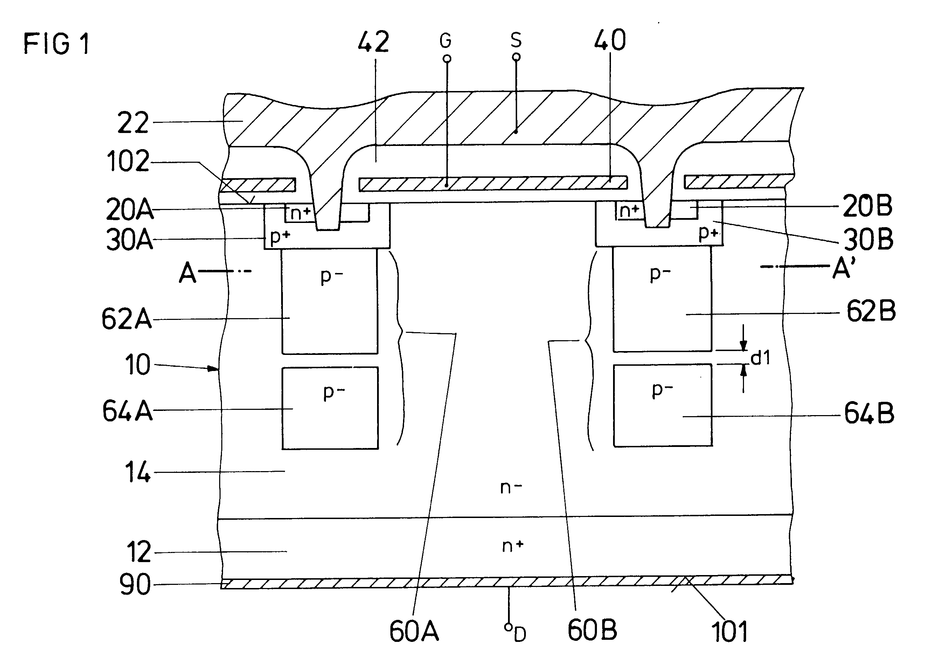

Ein derartiges als vertikaler MOSFET ausgebildetes Halbleiterbauelement ist beispielsweise aus J. Tihanyi: "A Qualitative Study of the DC Performance of SIPMOS Transistors", Siemens Forschungs- und Entwicklungsbericht Bd. 9 (1980) Nr. 4, Springer Verlag, Seite 181, Figure 1c, bekannt. Der bekannte MOSFET weist eine n⁺-dotierte Drain-Zone im Bereich einer Rückseite eines Halbleiterkörpers und eine n⁺-dotierte Source-Zone im Bereich einer Vorderseite des Halbleiterkörpers auf, wobei die Source-Zone in dem Halbleiterkörper von einer p⁺-dotierten Kanalzone umgeben ist. Zwischen der Kanalzone und der Drain-Zone erstreckt sich eine n⁻dotierte Driftzone welche benachbart zu einer sich ebenfalls an die Kanalzone anschließenden p⁻dotierten Zone ausgebildet ist. Eine isoliert gegenüber der Kanalzone angeordnete Gate-Elektrode ermöglicht bei Anlegen eines Ansteuerpotentials die Ausbildung eines leitenden Kanal zwischen der Source-Zone und der Driftzone.

Ein derartiges als MOSFET ausgebildetes Halbleiterbauelement mit einer n-dotierten Drain-Zone, einer n-dotierten Source-Zone, die von einer Kanalzone umgeben, und mit einer n-dotierten Driftstrecke, die benachbart zu einer p-dotierten Zone ausgebildet ist, ist weiterhin aus der US 5,216,275 und der US 4,754,310 bekannt.

Derartige MOS-Transistoren zeichnen sich durch einen geringen Einschaltwiderstand und eine hohe Durchbruchspannung aus.

Bei diesen MOS-Transistoren sind die Source-Zone und die Kanalzone üblicherweise mittels einer Source-Elektrode kurzgeschlossen, so dass die p-dotierte Zone, welche sich an die Kanalzone anschließt, auf Source-Potential liegt. Auch in leitendem Zustand des MOSFET, dass heißt, wenn ein leitender Kanal in der Kanalzone zwischen der Source-Zone und der Driftzone ausgebildet ist und eine Spannung zwischen der Source-Zone und der Drain-Zone anliegt, kommt es zu einem Spannungsabfall über der Driftstrecke. Hieraus resultiert eine Potentialdifferenz zwischen der p-dotierten Zone und der Driftstrecke, welche nahe der Drain-Zone am größten ist und wodurch sich im Grenzbereich zwischen der p-dotierten Zone und der Driftstrecke eine Raumladungszone ausbildet, die den leitenden Kanal in der Driftstrecke abschnüren kann.

Aus der DE 198 15 907 C1 ist ein durch Feldeffekt steuerbares Halbleiterbauelement mit einer n-dotierten Drain-Zone, einer n-dotierten Source-Zone, einer die Source-Zone umgebenden p-dotierten Kanalzone und einer zwischen der Source-Zone und der Drain-Zone ausgebildeten n-dotierten Driftstrecke bekannt, wobei in der Driftstrecke eine Anzahl von beabstandeten p-dotierten Zonen ausgebildet sind. Zur Ansteuerung ist eine Gate-Elektrode vorgesehen, die isoliert gegenüber der Kanalzone ausgebildet ist. Sperrt das Halbleiterbauelement so breitet sich bei Anlegen einer Spannung zwischen der Source- und Drain-Zone ausgehend von der Source-Zone eine Raumladungszone aus, die sukzessive die beabstandet angeordneten p-dotierten Zonen in der Drifstrecke erfasst. Diese Zonen und die daran anschließenden Bereiche der Driftzone werden auf diese Weise ausgeräumt, das heißt freie Ladungsträger rekombinieren und es tritt ein Verarmung an freien Ladungsträgern in der Driftstrecke ein, woraus eine hohe Durchbruchspannung resultiert. Um das Halbleiterbauelement nach dem Sperren wieder leitend zu machen müssen die floatend angeordneten -das heißt die nicht an ein festes Potential angeschlossenen- p-dotierten Bereichen wieder entladen werden. Dazu ist ein Injektor vorgesehen, der p-Ladungsträger in die Driftzone, bzw. die p-dotierten Zonen injiziert.

Ziel der vorliegenden Erfindung ist es ein Halbleiterbauelement, insbesondere ein mittels Feldeffekt steuerbares Halbleiterbauelement, zur Verfügung zu stellen, das einen geringen Einschaltwiderstand und eine hohe Durchbruchspannung aufweist und bei dem in leitenden Zustand ein Abschnüren des leitenden Kanals in der Driftzone verringert ist.

Dieses Ziel wird durch ein Halbleiterbauelement gemäß den Merkmalen des Anspruchs 1 gelöst.

Danach weist das Halbleiterbauelement eine erste Anschlusszone eines ersten Leitungstyps und eine zweite Anschlusszone des ersten Leitungstyps auf. Die zweite Anschlusszone ist mittels einer Kanalzone von einer Driftzone getrennt, die sich ausgehend von der Kanalzone bis an die erste Anschlusszone erstreckt. Des weiteren ist eine isoliert gegenüber der Kanalzone ausgebildete Steuerelektrode vorgesehen, die zur Ausbildung eines leitenden Kanals in der Kanalzone zwischen der zweiten Anschlusszone und der Driftzone dient.

In der Driftzone ist wenigstens eine Kompensationszone des zweiten Leitungstyps ausgebildet, wobei die Kompensationszone vorzugsweise säulenförmig ausgebildet ist und wenigstens zwei beabstandet zueinander angeordnete Segmente aufweist. Erfindungsgemäß ist der Abstand zwischen zwei benachbarten Segmenten derart gewählt, dass die Punch-Through-Spannung zwischen den beiden Segmenten maximal der Spannung entspricht, der sich einstellt wenn bei leitend angesteuertem Halbleiterbauelement die Driftstrecke von einem Strom durchflossen wird, der das Doppelte des Nennstroms beträgt und wenn die Temperatur des Halbleiterkörpers vorzugsweise maximal 150°C beträgt.

In absoluten Werten ist die Punch-Through-Spannung dabei vorzugsweise kleiner als 10V.

Der Nennstrom ist der Strom, auf den das Halbleiterbauelement für einen langfristigen Betrieb ausgelegt ist. Der Nennstrom wird dabei maßgeblich durch das Gehäuse und dessen Fähigkeit Wärme abzuleiten bestimmt.

Bei zwei gleichartig dotierten Bereichen, die durch einen komplementär dotierten Bereich getrennt sind, bezeichnet die sogenannte Punch-Through-Spannung allgemein den Wert der Potentialdifferenz zwischen diesen Bereichen, bei welchem eine von einem der beiden Bereiche ausgehende Raumladungszone den anderen der beiden Bereiche erfasst.

Das erfindungsgemäße Halbleiterbauelement funktioniert als MOS-Transistor, wobei die erste Zone als Drain-Zone, die zweite Zone als Source-Zone und die Steuerelektrode als Gate-Elektrode dient.

Bei leitend angesteuertem Halbleiterbauelement nehmen die floatend in der Driftzone angeordneten Segmente der Kompensationszone, also die Segmente, die nicht an die Kanalzone angeschlossen sind, einen Potentialwert an, der zwischen dem Potential an der ersten Anschlusszone und dem Potential an der Kanalzone, bzw. dem Potential an der mit der Kanalzone kurzgeschlossenen zweiten Anschlusszone, liegt. Die Potentialdifferenz zwischen diesen floatend ausgebildeten Segmenten und den umgebenden Bereichen der Driftzone ist dabei geringer als bei bekannten MOS-Transistoren, bei denen die gesamte Kompensationszone auf Source-Potential liegt. Der sogenannte Junction-Effekt, der die Abschnürung des leitenden Kanals in der Driftstrecke bezeichnet, ist bei dem erfindungsgemäßen Halbleiterbauelement dadurch verringert.

Sperrt das Halbleiterbauelement, so bildet sich ausgehend von der zweiten Anschlusszone, bzw. der Kanalzone, eine Raumladungszone aus, die mit steigender Spannung sukzessive die weiter von der Kanalzone entfernt liegenden Segmente der Kompensationszone erfasst.

Die Ladungsträgerkonzentrationen in der Kompensationszone und in den die Kompensationszone umgebenden Bereichen der Driftzone sind vorzugsweise so aufeinander abgestimmt, dass etwa gleich viele Ladungsträger des ersten und zweiten Leitungstyps vorhanden sind. Dies führt beim Anlegen einer Sperrspannung und nicht angesteuerter Steuerelektrode dazu, dass die Kompensationszonen und die die Kompensationszonen umgebenden Bereiche vollständig ausgeräumt werden, das heißt p-Ladungsträger wandern zu der Zone, bzw. der Elektrode, die auf dem negativeren Potential liegt, und n-Ladungsträger wandern zu der Zone, bzw. der Elektrode die auf dem positiveren Potential liegt. Bei Anlegen einer positiven Sperrspannung zwischen Drain und Source wandern p-Ladungsträger zur Source-Elektrode und n-Ladungsträger zur Drain-Elektrode. Das Ausräumen der Kompensationszone und der umgebenden Driftzone bewirkt, dass bei Anliegen der maximal möglichen Sperrspannung vor Erreichen eines Durchbruchs keine freien Ladungsträger in der Driftzone mehr vorhanden sind, woraus eine hohe Durchbruchspannung resultiert. In vollständig ausgeräumtem Zustand nimmt das Potential in der Driftstrecke und den Segmenten der Kompensationszone ausgehend von der Anschlusszone mit dem größeren Potential zu der Anschlusszone mit dem geringeren Potential hin stetig ab.

Soll das Bauelement wieder leiten, wird die Steuerelektrode durch Anlegen eines geeigneten Ansteuerpotentials angesteuert, so dass sich ein leitender Kanal in der Kanalzone ausbildet. Beim Wiedereinschalten des Bauelements und Anlegen einer Spannung zwischen den ersten und zweiten Anschlusszonen, die geringer als die Spannung im Sperrfall ist, bleiben die Segmente der Kompensationszonen, die floatend in der Driftzone ausgebildet sind, zunächst noch aufgeladen, weil die in den Segmenten der Kompensationszonen keine freien Ladungsträger vorhanden sind.

Beträgt dabei die Spannungsdifferenz zwischen der Kanalzone oder eines an die Kanalzone angeschlossenen Segments der Kompensationszone und eines beabstandet dazu angeordneten Segments der Kompensationszone den Wert der Punch-Through-Spannung zwischen diesen beiden Segmenten, so wird das Potential des beabstandet zu der Kanalzone angeordneten Segments an das Potential der Kanalzone angekoppelt. Das heißt das beabstandet angeordnete Segment wird teilweise entladen, wobei dessen Potential sich zunächst um den Wert der Punch-Through-Spannung von dem Potential der Kanalzone unterscheidet. Sind bei dem Bauelement mehr als zwei Segmente der Kompensationszone vorhanden, so findet dieser Vorgang für alle benachbarten Segmente statt.

Eine optimale Entladung der einzelnen Segmente würde beim Wiedereinschalten dann stattfinden, wenn alle Segmente an die Kanalzone angeschlossen wären. Hieraus resultieren allerdings die oben genannten Nachteile des Standes der Technik, nämlich ein Abschnüren des Kanals bei leitendem Bauelement.

Die erfindungsgemäße Dimensionierung, wonach die Punch-Through-Spannung maximal dem Spannungsabfall über dem eingeschalteten Bauelement bei doppeltem Nennstrom und vorzugsweise minimal dem Spannungsabfall über der Driftstrecke bei einfachem Nennstrom entspricht, bietet einen sehr guten Kompromiss zwischen den Anforderungen nach einer schnellen Entladung der Kompensationszonen beim Wiedereinschalten und einer möglichst geringen Abschnürung des Kanals in eingeschaltetem Zustand. Zudem kann auf die Verwendung eines zusätzlichen Injektors verzichtet werden.

Die vorliegende Erfindung wird nachfolgend in Ausführungsbeispielen anhand von Figuren näher erläutert. Es zeigt:
- Figur 1:: Erfindungsgemäßes Halbleiterbauelement in vertikaler Bauweise gemäß eines ersten Ausführungsbeispiels in seitlicher Ansicht im Querschnitt;
- Figur 2:: Querschnitt durch das Halbleiterbauelement gemäß Figur 1 in Draufsicht mit Kompensationszonen gemäß einer ersten Ausführungsform;
- Figur 3:: Querschnitt durch das Halbleiterbauelement gemäß Figur 1 in Draufsicht mit Kompensationszonen gemäß einer zweiten Ausführungsform;
- Figur 4:: Querschnitt durch das Halbleiterbauelement gemäß Figur 1 in Draufsicht mit Kompensationszonen gemäß einer dritten Ausführungsform;
- Figur 5:: Erfindungsgemäßes Halbleiterbauelement gemäß eines zweiten Ausführungsbeispiels in seitlicher Ansicht im Querschnitt;
- Figur 6:: Erfindungsgemäßes Halbleiterbauelement in lateraler Bauweise.

In den Figuren bezeichnen, sofern nicht anders angegeben, gleiche Bezugszeichen gleiche Teile und Bereiche mit gleicher Bedeutung.

Die vorliegende Erfindung wird nachfolgend anhand eines n-leitenden MOS-Transistors erläutert, wobei die Erfindung selbstverständlich auch auf p-leitende Transistoren anwendbar ist, wobei dazu die im folgenden n-leitenden Bereiche durch p-leitende Bereiche und die im folgenden p-leitenden Bereiche durch n-leitende Bereiche zu ersetzen sind. n-dotierte Bereiche bilden im folgenden dotierte Bereiche des ersten Leitungstyps und p-dotierte Bereiche bilden im folgenden dotierte Bereiche des zweiten Leitungstyps.

Figur 1 zeigt ein erstes Ausführungsbeispiel eines erfindungsgemäßen Halbleiterbauelements in Seitenansicht im Querschnitt. Das Bauelement weist einen Halbleiterkörper 10 auf, der im Bereich einer Rückseite 101 eine n-dotierte erste Anschlusszone 12 und im Bereich einer der Rückseite gegenüberliegenden Vorderseite 102 eine n-dotierte zweite Anschlusszone 20A, 20B aufweist.

Die in dem Ausführungsbeispiel gemäß Figur 1 wannenartig ausgebildete zweite Anschlusszone 20A, 20B ist in dem Halbleiterkörper von einer ebenfalls wannenartig ausgebildeten p-dotierten Kanalzone 30A, 30B umgeben, wobei die Kanalzone 30A, 30B die zweite Anschlusszone 20A, 20B von einer n-dotierten Driftzone 14 trennt, welche sich zwischen der Kanalzone 30A, 30B und der ersten Anschlusszone 12 erstreckt.

Das in Figur 1 dargestellte Halbleiterbauelement funktioniert als MOS-Transistor, wobei die erste Anschlusszone 12 als Drain-Zone des Transistors dient. Auf die Rückseite 101 des Halbleiterkörpers 10 ist in dem Ausführungsbeispiel eine Metallisierung 90 zur Bildung einer Drain-Elektrode D aufgebracht. Die zweite Anschlusszone 20A, 20B dient als Source-Zone des MOS-Transistors, wobei das in Figur 1 dargestellte Bauelement mehrere Source-Zonen 20A, 20B aufweist, von denen in Figur 1 zwei dargestellt sind, die in lateraler Richtung des Halbleiterkörpers 10 beabstandet zueinander angeordnet sind. Oberhalb des Halbleiterkörpers 10 ist eine Gate-Elektrode 40, G ausgebildet, die mittels einer Isolationsschicht 42 gegenüber dem Halbleiterkörper 10 isoliert ist und welche sich in lateraler Richtung des Halbleiterkörpers 10 jeweils von der zweiten Anschlusszone 20A, 20B über die Kanalzone 30A, 30B bis zu der Driftzone 14 erstreckt. Des weiteren ist eine gegenüber der Gate-Elektrode G isolierte Elektrode 22 vorgesehen, die als Source-Elektrode dient und die an die zweite Anschlusszone 20A, 20B angeschlossen ist und außerdem die zweite Anschlusszone 20A, 20B mit der Kanalzone 30A, 30B kurzschließt.

Die Source-Zonen 20A, 20B und die die Source-Zonen 20A, 20B umgebenden Kanalzonen 30A, 30B sind jeweils Bestandteil einer sogenannten Zelle des Halbleiterbauelements. Die Source-Elektrode 22 und die Gate-Elektrode 40 ist wie auch die Drain-Zone 12, bzw. die Drain-Elektrode 90, allen Zellen des MOS-Transistors gemeinsam. Jede der Zellen des Halbleiterbauelements funktioniert wie ein MOS-Transistor, wobei durch die gemeinsame Ansteuerung aller Zellen mittels der Gate-Elektrode 40, der Source-Elektrode 22 und der Drain-Elektrode 90 eine Vielzahl derartiger "kleiner" MOS-Transistoren parallelgeschaltet sind, die gemeinsame den MOS-Transistor bilden. Die Darstellung des zellenartigen Aufbaus des erfindungsgemäßen Halbleiterbauelements, wobei in Figur 1 zwei in lateraler Richtung beabstandet angeordnete Zellen gezeigt sind, dient der Veranschaulichung einer bevorzugten Ausführungsform. Ein ordnungsgemäßes Funktionieren des Bauelements ist bereits mit einer einzigen Zelle gewährleistet.

Erfindungsgemäß ist bei dem Halbleiterbauelement wenigstens eine Kompensationszone 60A, 60B in der Driftzone ausgebildet, wobei die Kompensationszone 60A, 60B wenigstens zwei beabstandet voneinander angeordnete Segmente 62A, 64A, 62B, 64B aufweist. In dem Ausführungsbeispiel gemäß Figur 1 ist unterhalb jeder Kanalzone 30A, 30B eine säulenartig ausgebildete Kompensationszone 60A, 60B vorgesehen, die sich in vertikaler Richtung des Halbleiterkörpers 10 ausgehend von den Kanalzonen 30A, 30B in Richtung der Drain-Zone 12 erstreckt. Ein erstes Segment 62A, 62B ist in dem Ausführungsbeispiel gemäß Figur 1 jeweils mit einer der Kanalzonen 30A, 30B verbunden, zweite Segmente der Kompensationszonen 60A, 60B sind beabstandet zu den ersten Segmenten 62A, 62B unterhalb der ersten Segmente 62A, 62B angeordnet.

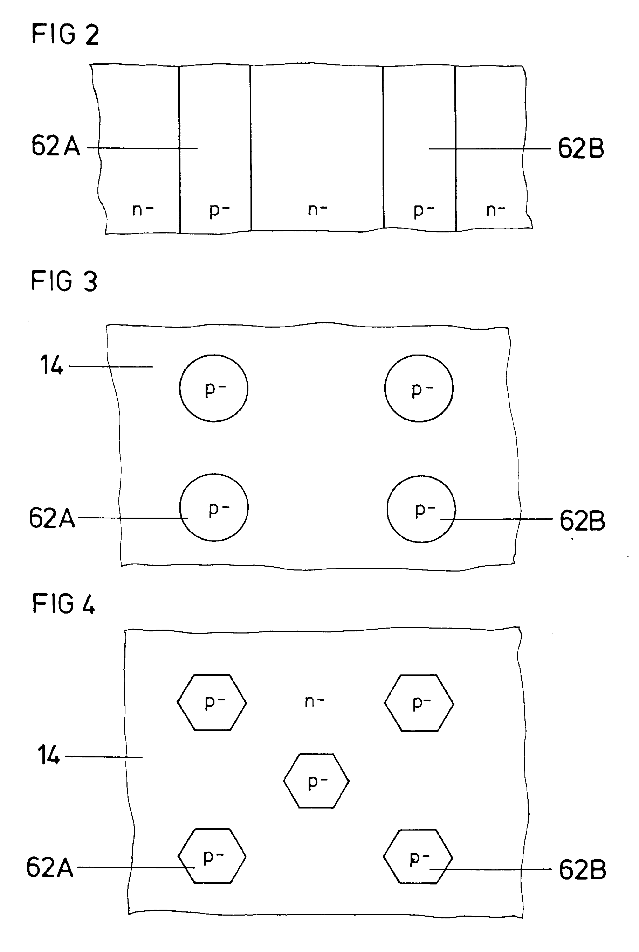

Figur 2 zeigt einen Querschnitt durch das Halbleiterbauelement gemäß Figur 1 in einer Querschnittsebene A-A'. Bei dem Ausführungsbeispiel gemäß Figur 3 sind die Kompensationszonen 62A, 62B in einer lateralen Richtung des Halbleiterkörpers 10 langgestreckt ausgebildet. Die in Figur 3 nicht dargestellten darüberliegenden Kanalzonen und Source-Zonen sind an die Geometrie der Kompensationszonen 62A, 62B angepasst und dementsprechend langgestreckt ausgebildet.

Figur 3 zeigt ein weiteres Ausführungsbeispiel, bei welchem die Kompensationszonen 62A, 62B säulenartig mit rundem Querschnitt ausgebildet sind. Bei dem im Figur 4 dargestellten Ausführungsbeispiel sind die Kompensationszonen 62A, 62B ebenfalls säulenförmig mit sechseckförmigem Querschnitt ausgebildet.

Der Abstand der einzelnen Segmente 62A, 64A, und 62B, 64B der Kompensationszonen 60A, 60B ist erfindungsgemäß derart gewählt, dass die Punch-Through-Spannung zwischen diesen Segmenten maximal der Spannung entspricht, die über der Driftstrecke bei doppeltem Nennstrom anliegt. Die Punch-Through-Spannung bezeichnet die maximal mögliche Spannungsdifferenz zwischen den zwei benachbarten Segmenten 62A, 64A und 62B, 64B. Erreicht die Spannungsdifferenz zwischen zwei benachbarten Segmenten den Wert der Punch-Through-Spannung, kommt es zu einem Ladungsträgeraustausch zwischen diesen benachbarten Segmenten, wodurch ein weiteres Ansteigen einer Spannungsdifferenz verhindert wird.

Die Punch-Through-Spannung ist von der Dotierung der Segmente 62A, 64A, 62B, 64B, der Dotierung der Driftzone 14 zwischen den Segmenten und dem Abstand d1 zweier benachbarter Segmente abhängig.

Vorzugsweise sind die in Figur 1 oberen Segmente 62A, 62B der Kompensationszonen 60A, 60B höher p-dotiert als die unteren Segmente 62A, 62B.

Die Funktionsweise des erfindungsgemäßen Halbleiterbauelements wird nachfolgend anhand von Figur 1 erläutert.

Zunächst wird davon ausgegangen, dass sich das Halbleiterbauelement bereits seit langer Zeit in einem "Ruhezustand" befindet, bei dem keine Gate-Source-Spannung zwischen der Gate-Elektrode G und der Source-Elektrode S anliegt, und bei dem keine Drain-Source-Spannung zwischen der Drain-Elektrode D und der Source-Elektrode S anliegt, so dass in den Kompensationszonen und in der Driftzone freie Ladungsträger vorhanden sind. Bei Anlegen eines positiven Ansteuerpotentials an die Gate-Elektrode G bildet sich in der Kanalzone 30A, 30B zwischen der Source-Zone 20a, 20B und der Driftzone 14 ein leitender Kanal aus. Bei Anlegen einer positiven Spannung zwischen der Drain-Elektrode 90 und der Source-Elektrode 22 kommt es dadurch zu einem Ladungsträgerfluss von der Drain-Zone 12 zu der Source-Zone 20A, 20B. Hierbei kommt es zu einem Spannungsabfall über der Driftstrecke 14, wobei das Potential der Driftstrecke 14 im Bereich der unteren Segmente 64A, 64B größer ist als im Bereich der oberen Segmente 62A, 62B. Die oberen Segmente 62A, 62B sind an die Kanalzone 30A, 30B bzw. die Source-Elektrode 22 angeschlossen und befinden sich damit auf dem niedrigen Source-Potential. Die unteren Segmente 64A, 64B, die beabstandet zu den Segmenten 62A, 62B angeordnet sind, nehmen p-Ladungsträger aus der Driftstrecke 14 auf und nehmen dadurch ein höheres Potential als die oberen Segmente 62A, 62B an. Die Potentialdifferenz zwischen den unteren Segmenten 64A, 64B und der Driftstrecke 14 ist bei dem erfindungsgemäßen Halbleiterbauelement geringer als bei derartigen Bauelementen nach dem Stand der Technik, bei welchen die gesamte Kompensationszone an die Source-Elektrode angeschlossen ist. Der Effekt einer Abschnürung des leitenden Kanals in der Driftstrecke 14 ist bei dem erfindungsgemäßen Halbleiterbauelement durch die beabstandet angeordneten Segmente 62A, 64A und 62B, 64B damit geringer als bei derartigen Bauelementen nach dem Stand der Technik.

Wird kein Ansteuerpotential an die Gate-Elektrode G angelegt, so sperrt der MOS-Transistor bei Anlegen einer positiven Spannung zwischen der Drain-Elektrode 90 und der Source-Elektrode 22. Ausgehend von den Kanalzonen 30A, 30B breiten sich dabei Raumladungszonen in vertikaler Richtung des Halbleiterkörpers 10 aus, wobei die Kompensationszonen 60A, 60B mit zunehmender Sperrspannung und zunehmender Ausweitung der Raumladungszonen ausgeräumt werden, das heißt freie p-Ladungsträger der Kompensationszonen 60A, 60B wandern zu Source-Elektrode und freie n-Ladungsträger wandern zu der Drain-Elektrode D. woraus eine Verarmung an Ladungsträgern in der Driftzone 14 und den Kompensationszonen 60A, 60B resultiert. Vorzugsweise sind die Kompensationszonen 60A, 60B und die Driftstrecke 14 derart dotiert, dass die Kompensationszonen 60A, 60B und die Driftstrecke 14 jeweils vollständig ausgeräumt werden, wodurch bei maximaler Sperrspannung keine freien Ladungsträger mehr vorhanden sind.

Bei maximaler Sperrspannung herrscht dann in den Kompensationszonen 60A, 60B und in der Driftstrecke 14 qualitativ die gleiche Potentialverteilung vor, das heißt das Potential nimmt ausgehend von der Drain-Elektrode 90 zu den Kanalzonen 30A, 30B hin ab. Aufgrund eines Querfeldes zwischen der Kompensationszonen 60A, 60B und der Driftzone unterscheiden sich die Potentiale allerdings etwas.

Beim Einschalten des Bauelements, das heißt bei Anlegen eines positiven Ansteuerpotentials an die Gate-Elektrode G und einer verringerten Drain-Source-Spannung nehmen die an die Kanalzonen 30A, 30B angeschlossenen Segmente 62A, 62B der Kompensationszonen rasch den Wert des Source-Potentials an. Die beabstandet dazu angeordneten Segmente 64A, 64B, in denen negativ geladene Akzeptoratome vorhanden sind, weisen zunächst ein negatives Potential auf. Erreicht durch den Ladungsabbau in den Segmenten 62A, 62B beim Wiedereinschalten die Spannungsdifferenz zwischen den Segmenten 62A, 64A und 62B, 64B den Wert der Punch-Through-Spannung zwischen diesen Segmenten, so fließen Ladungsträger, nämlich Löcher, aus den in Figur 1 oberen Segmenten 62A, 62B in die unteren Segmente 64A, 64B. Dadurch wird verhindert, dass die Potentialdifferenz zwischen den beiden benachbarten Segmenten größer wird als der Wert der Punch-Through-Spannung. Die Punch-Through-Spannung zwischen den beiden benachbarten Segmenten ist unter anderem von dem Abstand d1 abhängig. Während es für den zuvor geschilderten Fall, bei welchem das Bauelement bereits seit langer Zeit eingeschaltet ist, angestrebt ist, den Abstand zwischen den benachbarten Segmenten 62A, 64A und 62B, 64B möglichst groß zu machen, um die Potentialdifferenz zwischen den Segmenten 64A, 64B und der Driftzone 14 möglichst klein zu machen, ist es beim Wiedereinschalten des Bauelements erstrebenswert, den Abstand zwischen den Segmenten möglichst gering zu machen, um das nicht an die Kanalzonen 30A, 30B angekoppelte Segment 64A, 64B möglichst rasch zu entladen.

Die erfindungsgemäße Dimensionierung, wonach der Abstand zwischen diesen Segmenten 62A, 64A und 62B, 64B derart gewählt ist, dass die Punch-Through-Spannung einen Wert annimmt, welcher maximal dem Spannungsabfall über der Driftstrecke bei doppeltem Nennstrom entspricht, bietet einen sehr guten Kompromiss zwischen diesen widerstreitenden Effekten. Hieraus resultiert ein MOS-Transistor mit gutem Leitverhalten, einer hohen Sperrspannung und einem raschen Ladungsträgerabbau beim Wiedereinschalten. Ein zusätzlicher Injektor ist bei dem erfindungsgemäßen Halbleiterbauelement nicht erforderlich.

Der Abstand d1 zwischen den benachbarten Segmenten 62A, 64A und 62B, 64B beträgt vorzugsweise zwischen 0,5 und 4 µm, die Dotierung der Driftzone beträgt zwischen 5 x 10¹⁴ cm⁻³ und 5 x 10¹⁵ cm⁻³.

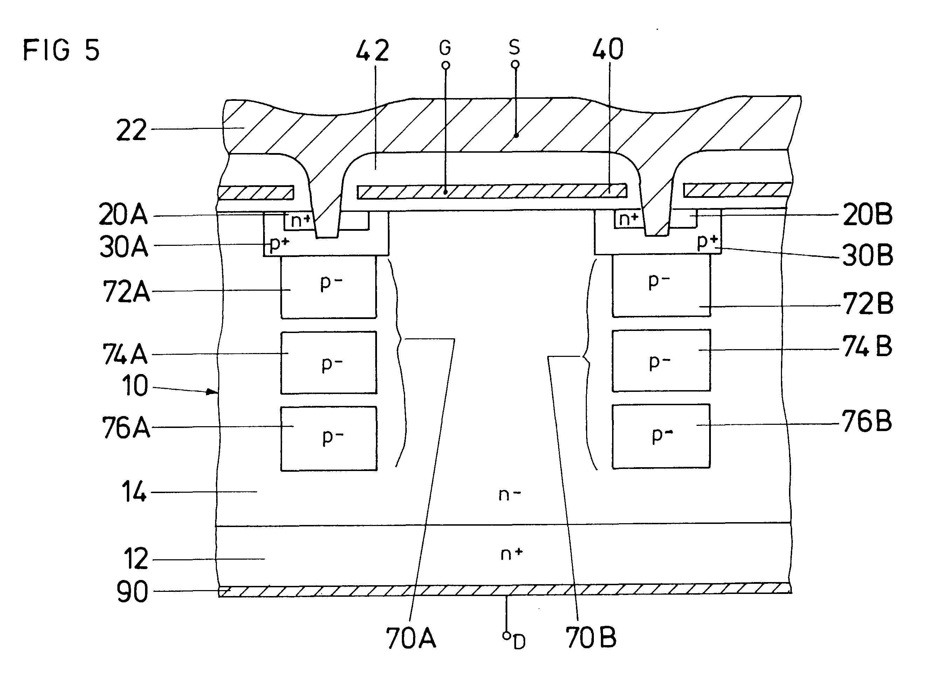

Figur 5 zeigt ein weiteres Ausführungsbeispiel eines erfindungsgemäßen Halbleiterbauelements, bei dem die unterhalb der Kanalzonen 30A, 30B angeordneten Kompensationszonen 70A, 70B jeweils drei beabstandet voneinander angeordnete Segmente 72A, 74A, 76A, und 72B, 74B, 76B aufweisen, wobei in dem Ausführungsbeispiel jeweils eines der Segmente 72A, 72B an die Kanalzone 30A, 30B angeschlossen ist.

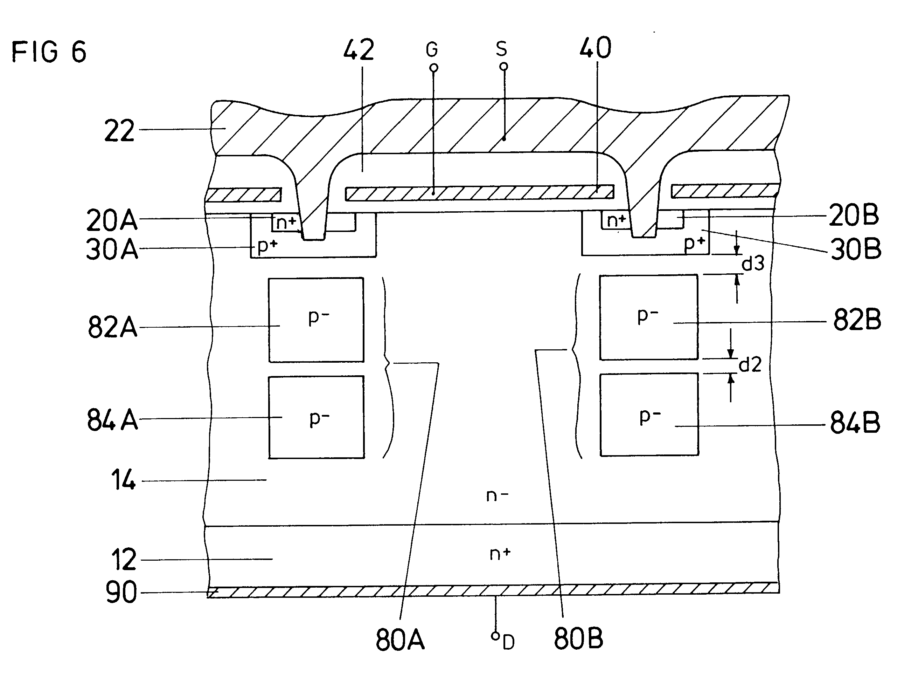

Figur 6 zeigt ein weiteres Ausführungsbeispiel eines erfindungsgemäßen Halbleiterbauelements, welches sich von dem in Figur 1 dargestellten dadurch unterscheidet, dass das der Kanalzone 30A, 30B zugewandte Segment 62A, 62B der Kompensationszonen 80A, 80B nicht mit der Kanalzone verbunden ist. Der Abstand der Segmente 62A, 62B von der Kanalzone 30A, 30B in vertikaler Richtung beträgt d3, der Abstand der Segmente 62A, 62B von den benachbarten Segmenten 64A, 64B beträgt d2. Die Abstände d2, d3 sind vorzugsweise derart gewählt, dass die Punch-Through-Spannung zwischen den Kanalzonen 30A, 30B und den Segmenten 62A, 62B und zwischen den Segmenten 82A, 84A und 82B, 84B geringer ist als die Drain-Source-Spannung bei einem Drain-Source-Strom, der in etwa dem doppelten Nennstrom entspricht.

Die zuvor genannten Dimensionierungen der Punch-Through-Spannung, wonach diese maximal dem Spannungsabfall über der Driftstrecke bei doppeltem Nennstrom entspricht gelten vorzugsweise für eine Temperatur von maximal 150°C. Bei höheren Temperaturen steigt der Spannungsabfall über der Driftstrecke bei gleichem Strom.

Figur 6 zeigt einen Ausschnitt eines Halbleiterkörpers 100 in dem ein Halbleiterbauelement gemäß eines weiteren Ausführungsbeispiels der Erfindung realisiert ist. Das dargestellte Bauelement ist als MOSFET in lateraler Bauweise ausgebildet. Das Bauelement weist einen n-dotierten Halbleiterkörper 100 auf, in dem ausgehend von einer Oberfläche des Halbleiterkörpers 100 eine stark n-dotierte Source-Zone 120 in einer p-dotierten Kanalzone 130 ausgebildet ist. Die Source-Zone 120 und die Kanalzone 130 sind mittels einer Source-Elektrode 122 kurzgeschlossen.

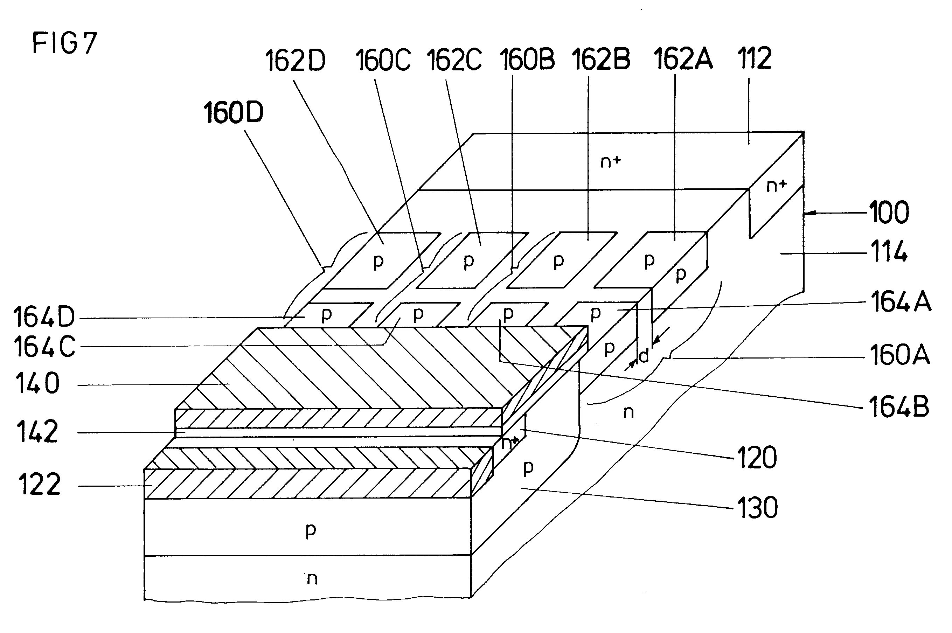

In lateraler Richtung beabstandet zu der Source-Zone 120 und der Kanalzone 130 ist ausgehend von der Oberfläche eine stark n-dotierte Drain-Zone in den Halbleiterkörper 100 eingebracht. Zwischen der Drain-Zone 112 und der Kanalzone ist eine n-dotierte Driftzone 114 ausgebildet, in der p-dotierte Kompensationszonen 160A, 160B, 160C, 160D ausgebildet sind, wobei jede der beabstandet zueinander angeordneten Kompensationszonen in dem Ausführungsbeispiel zwei Segmente 162A, 164A, 162B, 164B, 162C, 164C, 162D, 164D aufweist, die in lateraler Richtung des Halbleiterkörpers 100 beabstandet zueinander ausgebildet sind. Die Kompensationszonen 160A, 160B, 160C, 160D sind im wesentlichen säulenförmig ausgebildet und erstrecken sich in ihrer Längsrichtung in lateraler Richtung des Halbleiterkörpers 100. Eines der Segmente 164A, 164B, 164C, 164D jeder Kompensationszone 160A, 160B, 160C, 160D ist in dem Ausführungsbeispiel gemäß Figur 7 an die Kanalzone 130 angeschlossen.

Der Abstand d der einzelnen Segmente 162A, 164A, 162B, 164B, 162C, 164C, 162D, 164D jeder der Kompensationszonen 160A, 160B, 160C, 160D ist dabei so gewählt, dass die Punch-Through-Spannung zwischen den zwei benachbarten Segmenten einer Kompensationszone 160A, 160B, 160C, 160D maximal dem Spannungsabfall über der Driftstrecke 114 bei doppeltem Nennstrom entspricht.

Bei dem Bauelement gemäß Figur 7 ist des weiteren eine Gate-Elektrode 140 vorhanden, die gegenüber dem Halbleiterkörper 100 mittels einer Isolationsschicht 142 isoliert auf dem Halbleiterkörper 100 angeordnet ist und die sich in lateraler Richtung von der Source-Zone 120 bis an die Driftzone 114 erstreckt.

Das erfindungsgemäße Bauelement wurde vorstehend anhand eines n-leitenden MOSFET erläutert. Die Erfindung ist selbstverständlich auch auf p-leitende MOSFET anwendbar, wobei dann die zuvor beschriebenen n-dotierten Bereiche durch p-dotierte Bereiche zu ersetzen sind, und umgekehrt.

### Bezugszeichenliste

- D: Drain-Anschluß
- G: Gate-Anschluß
- S: Source-Anschluß
- 10: Halbleiterkörper
- 12: Drain-Zone
- 14: Drift-Zone
- 22: Source-Elektrode
- 20A, 20B: Source-Zone
- 40: Gate-Elektrode
- 42: Isolationsschicht
- 30A, 30B: Drain-Zone
- 30A, 30B: Kanalzone
- 90: Drain-Elektrode
- 100: Halbleiterkörper
- 101: Rückseite des Halbleiterkörpers
- 102: Vorderseite des Halbleiterkörpers
- 112: Drain-Zone
- 114: Driftstrecke
- 60A, 60B: Kompensationszone
- 122: Source-Elektrode
- 70A, 70B: Kompensationszone
- 140: Gate-Elektrode
- 142: Isolationsschicht
- 80A, 80B: Kompensationszone
- 160A, B, C, D: Kompensationszone
- 162A, B, C, D: erstes Segment der Kompensationszone
- 164A, B, C, D: zweites Segment der Kompensationszone
- 62A, 64A: Segmente der Kompensationszone 60A
- 62B, 64B: Segmente der Kompensationszone 60B
- 82A, 84A: Segmente der Kompensationszone 80A
- 82B, 84B: Segmente der Kompensationszone 80B
- 72A, 74A, 76A: Segmente der Kompensationszone 70A
- 72B, 74B, 76B: Segmente der Kompensationszone 70B

## Patentansprüche

1. Halbleiterbauelement, das folgende Merkmale aufweist:
- eine erste Anschlusszone (12) und eine zweite Anschlusszone (20A, 20B) eines ersten Leitungstyps (n),
- eine Kanalzone (30A, 30B) eines zweiten Leitungstyps (p) und eine Driftzone (14) eines ersten Leitungstyps, wobei die Driftzone zwischen der Kanalzone (30A, 30B) und der ersten Anschlusszone (12) und die Kanalzone (30A, 30B) zwischen der zweiten Anschlusszone (20A, 20B) und der Driftzone (14) ausgebildet ist,
- eine isoliert gegenüber der zweite Zone (30A, 30B) ausgebildete Steuerelektrode (40) zur Steuerung eines leitenden Kanals in der zweiten Zone (30A, 30B) zwischen der zweiten Zone (20A, 20B) und der Driftzone.
- eine zwischen der zweiten Zone (30A, 30B) und der ersten Zone ausgebildete Driftzone (14) des ersten Leitungstyps,
- wenigstens eine in der Driftzone (14) ausgebildete Kompensationszone (60A, 60B; 70A, 70B; 80A, 80B) des zweiten Leitungstyps, die wenigstens zwei voneinander beabstandete Segmente (62A, 64A, 62B, 64B; 72A, 74A, 76A, 72B, 74B, 76B; 82A, 84A, 86A, 82B, 84B, 86B) aufweist,
**dadurch gekennzeichnet, dass**
der Abstand zwischen zwei benachbarten Segmenten (62A, 64A; 72A, 74A; 82A, 84A) derart gewählt ist, dass die Punch-Through-Spannung zwischen diesen Segmenten (62A, 64A; 72A, 74A; 82A, 84A) maximal der Spannung entspricht, die bei doppeltem Nennstrom über der Driftstrecke (14) anliegt.

2. Halbleiterbauelement nach Anspruch 1, bei dem sich eines der Segmente (62A, 62B; 72A, 72B) der Kompensationszone (60A, 60B; 70A, 70B) unmittelbar an die zweite Zone (30A, 30B) anschließt.

3. Halbleiterbauelement nach Anspruch 1 oder 2, bei dem die Kompensationszone säulenförmig ausgebildet ist.

4. Halbleiterbauelement nach einem der vorangehenden Ansprüche, bei dem eines der Segmente (62A, 62B, 72A, 72B, 82A, 82B) höher dotiert ist als ein benachbartes Segment (64A, 64B, 74A, 74B, 84A, 84B) der Kompensationszone.

5. Halbleiterbauelement nach einem der vorangehenden Ansprüche, bei dem in der Driftzone (14) die Anzahl der Ladungsträger des ersten Leitungstyps (n) wenigstens annäherungsweise der Anzahl der Ladungsträger des zweiten Leitungstyps (p) entspricht.

6. Halbleiterbauelement nach einem der Ansprüche 1 bis 5, bei dem in der Driftzone die Anzahl der Ladungsträger des zweiten Leitungstyps (p) größer als die Anzahl der Ladungsträger des ersten Leitungstyps ist.

7. Halbleiterbauelement nach einem der vorangehenden Ansprüche, bei dem die Kompensationszone mehr als zwei beabstandet angeordnete Segmente aufweist.

8. Halbleiterbauelement nach einem der vorangehenden Ansprüche, bei dem die Dotierung der Driftzone 5·10¹⁴ cm⁻³ und der Abstand der benachbarten Segmente (62A, 62B, 64A, 64B) 2-4 µm beträgt.

9. Halbleiterbauelement nach einem der vorangehenden Ansprüche, bei dem die Dotierung der Driftzone 2·10¹⁵ cm⁻³ und der Abstand der benachbarten Segmente (62A, 62B, 64A, 64B) 1-2 µm beträgt.

10. Halbleiterbauelement nach einem der vorangehenden Ansprüche, bei dem die Dotierung der Driftzone 5·10¹⁵ cm⁻³ und der Abstand der benachbarten Segmente (62A, 62B, 64A, 64B) 0.5-1.5 µm beträgt.
